# EUROPEAN PATENT APPLICATION

(11) **EP 3 654 392 A1**
(43) Date of publication of application: **20.05.2020**
(21) Application number: 19207480.5
(22) Date of filing: 06.11.2019
(51) Int. Cl.: H01L 35/22, H01L 35/32

(54) **THERMOELECTRIC CONVERSION ELEMENT, THERMOELECTRIC CONVERSION SYSTEM, POWER GENERATION METHOD OF THERMOELECTRIC CONVERSION ELEMENT, AND POWER GENERATION METHOD OF THERMOELECTRIC CONVERSION SYSTEM**

(30) Priority: 19.11.2018 JP 2018216459
(71) Applicant: TOYOTA JIDOSHA KABUSHIKI KAISHA, Toyota-shi, Aichi-ken, 471-8571 (JP); Kyushu University, National University Corporation, Nishi-ku Fukuoka-shi Fukuoka 8190395 (JP)
(72) Inventor: SUGIMOTO, Kazuhiro, Aichi-ken, 471-8571 (JP); MUNETOH, Shinji, Fukuoka, 8190395 (JP); FURUKIMI, Osamu, Fukuoka, 8190395 (JP)
(74) Representative: J A Kemp LLP

(57) **Abstract**

A thermoelectric conversion element (100, 200, 300) includes a p-type semiconductor (10), an n-type semiconductor (20), and a depletion layer (30) located at a pn junction interface of the p-type semiconductor (10) and the n-type semiconductor (20). At least one of the p-type semiconductor (10) and the n-type semiconductor (20) is a degenerate semiconductor.

## Description

### BACKGROUND OF THE INVENTION

### 1. Field of the Invention

The invention relates to thermoelectric conversion elements, thermoelectric conversion systems, power generation methods of thermoelectric conversion elements, and power generation methods of thermoelectric conversion systems.

### 2. Description of Related Art

Internal combustion engines for automobiles, aircrafts, etc. use energy produced by combustion of fossil fuels. At present, the energy efficiency of the internal combustion engines is only about 30%, and most of the energy is released as thermal energy. In order to effectively use this thermal energy, various thermoelectric materials using the Seebeck effect have been studied.

Thermoelectric materials using the Seebeck effect generate power using the difference in electromotive force based on the temperature difference. However, power generation modules assembled using such thermoelectric materials may generate a reduced amount of power as the temperature difference is reduced due to heat conduction etc. A cooling apparatus etc. is therefore required for the power generation modules in order to maintain the temperature difference. Accordingly, the power generation modules become complicated.

WO 2015/125823 proposes a semiconductor single crystal that can generate power even without a temperature difference between semiconductor portions. The semiconductor single crystal of the WO 2015/125823 has an n-type semiconductor portion, a p-type semiconductor portion, and an intrinsic semiconductor portion therebetween, and the intrinsic semiconductor portion has a smaller bandgap than the n-type semiconductor portion and the p-type semiconductor portion. WO 2015/125823 gives as a specific example of the semiconductor single crystal a clathrate compound like BaₓAu_{y}Si_{46-y} produced by a crystal growth process such as the Czochralski process.

### SUMMARY OF THE INVENTION

As described above, WO 2015/125823 proposes a semiconductor single crystal that can generate power even without a temperature difference between semiconductor portions, and gives as an example of such a semiconductor single crystal a clathrate compound like BaₓAu_{y}Si_{46-y} produced by a crystal growth process such as the Czochralski process.

According to the invention, a thermoelectric conversion element can generate power even without a temperature difference and can be produced from inexpensive materials and/or easily.

The inventors studied the above problem and arrived at the invention described below.

A first aspect of the invention relates to a thermoelectric conversion element. The thermoelectric conversion element includes: a p-type semiconductor; an n-type semiconductor; and a depletion layer located at a pn junction interface of the p-type semiconductor and the n-type semiconductor. At least one of the p-type semiconductor and the n-type semiconductor is a degenerate semiconductor.

With the above configuration, the thermoelectric conversion element can generate power even without a temperature difference and can be produced from inexpensive materials and/or easily.

In the thermoelectric conversion element, both the p-type semiconductor and the n-type semiconductor may be degenerate semiconductors.

In the thermoelectric conversion element, bandgaps of materials forming the p-type semiconductor, the n-type semiconductor, and the depletion layer may be substantially a same.

In the thermoelectric conversion element, the p-type semiconductor may be silicon doped with a p-type dopant, and the n-type semiconductor may be silicon doped with an n-type dopant.

In the thermoelectric conversion element, the p-type dopant may be selected from the group consisting of boron, aluminum, gallium, indium, palladium, and combinations of at least two of the boron, the aluminum, the gallium, the indium, and the palladium, and the n-type dopant may be selected from the group consisting of phosphorus, antimony, arsenic, titanium, and combinations of at least two of the phosphorus, the antimony, the arsenic, and the titanium.

In the thermoelectric conversion element, the p-type semiconductor may be silicon doped with the boron serving as the p-type dopant, and the n-type semiconductor may be silicon doped with the phosphorus serving as the n-type dopant.

A second aspect of the invention relates to a thermoelectric conversion system. The thermoelectric conversion system includes two or more thermoelectric conversion elements electrically connected in series. Each of the thermoelectric conversion element includes a p-type semiconductor, an n-type semiconductor, and a depletion layer located at a pn junction interface of the p-type semiconductor and the n-type semiconductor. At least one of the p-type semiconductor and the n-type semiconductor is a degenerate semiconductor.

A third aspect of the invention relates to a power generation method of a thermoelectric conversion element. The thermoelectric conversion element includes a p-type semiconductor, an n-type semiconductor, and a depletion layer located at a pn junction interface of the p-type semiconductor and the n-type semiconductor. At least one of the p-type semiconductor and the n-type semiconductor is a degenerate semiconductor. The power generation method includes heating the thermoelectric conversion element to 100°C or higher to cause the thermoelectric conversion element to generate power.

A fourth aspect of the invention relates to a power generation method of a thermoelectric conversion system. The thermoelectric conversion system includes two or more thermoelectric conversion elements electrically connected in series. Each of the thermoelectric conversion elements includes a p-type semiconductor, an n-type semiconductor, and a depletion layer located at a pn junction interface of the p-type semiconductor and the n-type semiconductor. At least one of the p-type semiconductor and the n-type semiconductor is a degenerate semiconductor. The power generation method includes heating the thermoelectric conversion system to 100°C or higher to cause the thermoelectric conversion system to generate power.

With the above configuration, the thermoelectric conversion element or system can generate power even without a temperature difference and can be produced from inexpensive materials and/or easily.

### BRIEF DESCRIPTION OF THE DRAWINGS

Features, advantages, and technical and industrial significance of exemplary embodiments of the invention will be described below with reference to the accompanying drawings, in which like numerals denote like elements, and wherein:
FIG. 1 is a view showing one mode of a thermoelectric conversion element of the invention;
FIG. 2 is a view showing another mode of the thermoelectric conversion element of the invention;
FIG. 3 is a view showing still another mode of the thermoelectric conversion element of the invention;

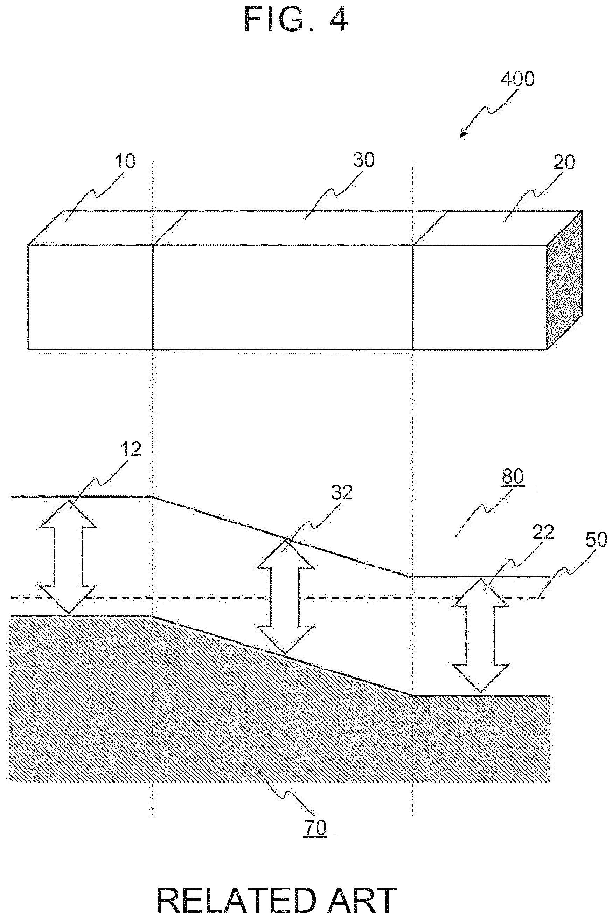

FIG. 4 is a view showing a semiconductor element according to the related art, in which neither p-type semiconductor portion nor n-type semiconductor portion is a degenerate semiconductor;
FIG. 5 is a view showing one mode of a thermoelectric conversion system of the invention;
FIG. 6 is a view showing another mode of the thermoelectric conversion system of the invention;
FIG. 7 is a graph showing the relationship between the ambient temperature and the electromotive force of a thermoelectric conversion element of an example;
FIG. 8 is a graph showing the relationship between the voltage and the current of the thermoelectric conversion element of the example at each ambient temperature; and
FIG. 9 is a graph showing the relationship between the ambient temperature and the electromotive force of the thermoelectric conversion element of the example.

### DETAILED DESCRIPTION OF EMBODIMENTS

### Thermoelectric Conversion Element

As described above, WO 2015/125823 proposes a semiconductor single crystal that can generate power even without a temperature difference between semiconductor portions, and gives as an example of such a semiconductor single crystal a clathrate compound like BaₓAu_{y}Si_{46-y} produced by a crystal growth process such as the Czochralski process.

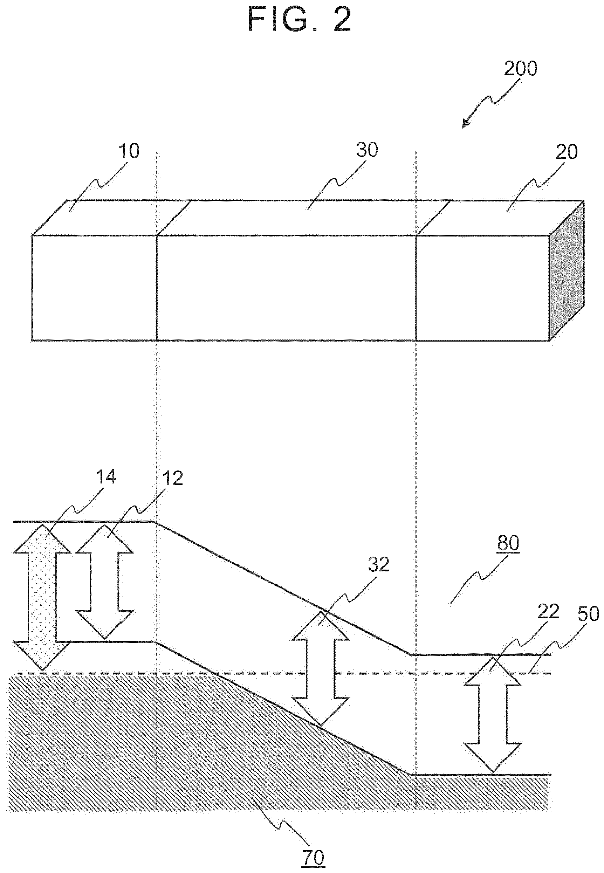

According to WO 2015/125823, it is preferable that the bandgap in an intrinsic semiconductor portion between the semiconductor portions of the semiconductor single crystal be 0.4 eV or less. The bandgap of such a semiconductor single crystal is changed to the states shown in FIGS. 2, 7, and 9 of WO 2015/125823 by changing the composition of elements forming the clathrate compound.

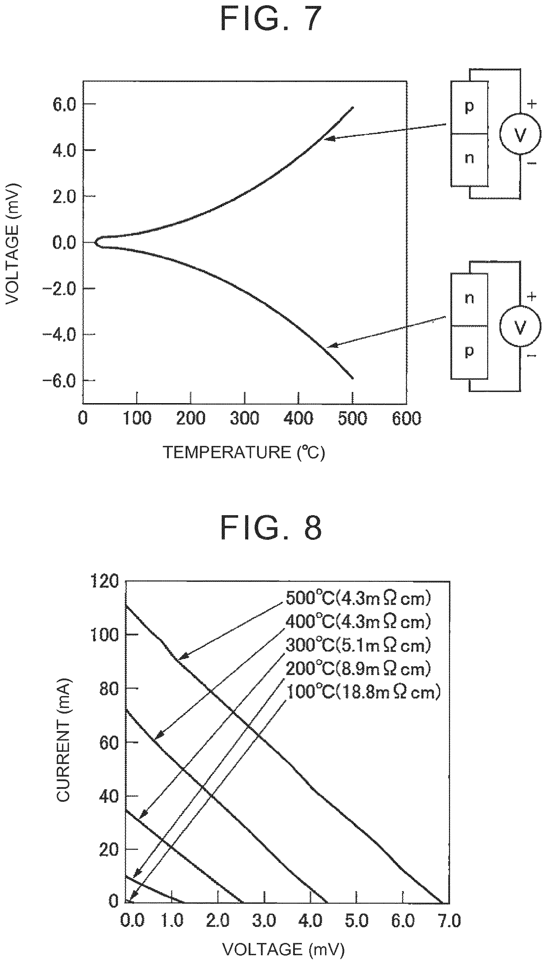

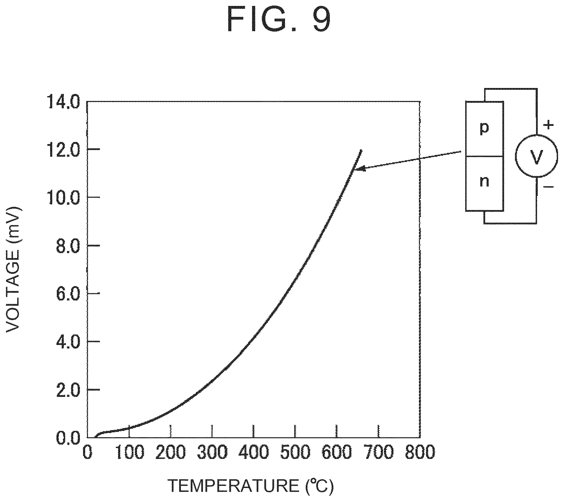

Specifically, WO 2015/125823 shows the bandgap in the intrinsic semiconductor portion between the semiconductor portions being smaller than the bandgaps in the p-type and n-type semiconductor portions (FIG. 2 of WO 2015/125823), the bandgap in the intrinsic semiconductor portion between the semiconductor portions being smaller than the bandgap in the n-type semiconductor portion (FIG. 7 of WO 2015/125823), and the bandgap in the intrinsic semiconductor portion between the semiconductor portions being smaller than the bandgap in the p-type semiconductor portion (FIG. 9 of WO 2015/125823).

On the other hand, a thermoelectric conversion element of the invention has p-type and n-type semiconductor portions and a depletion layer formed at the pn junction interface of the p-type and n-type semiconductor portions, and at least one of the p-type and n-type semiconductor portions, preferably both of the p-type and n-type semiconductor portions, are degenerate semiconductors.

Such a thermoelectric conversion element of the invention can generate power even without a temperature difference.

The thermoelectric conversion element of the invention can generate power even without a temperature difference both theoretically and practically for the following reason. Since the thermoelectric conversion element of the invention has the p-type and n-type semiconductor portions and the depletion layer formed at the pn junction interface of the p-type and n-type semiconductor portions, and at least one of the p-type and n-type semiconductor portions is a degenerate semiconductor. The bandgap in the depletion layer is therefore smaller than at least one of the magnitude of the energy for exciting (producing) electron-hole pairs in the p-type semiconductor portion and the magnitude of the energy for exciting (producing) electron-hole pairs in the n-type semiconductor portion.

Accordingly, even when the entire element is heated at a uniform temperature, the probability of electron excitation in the depletion layer (intrinsic semiconductor portion) is higher than that in the degenerate p-type and n-type semiconductor portions, and the carrier density in the depletion layer is relatively large. Carriers thus produced in the depletion layer, that is, electrons and holes, are diffused toward the low-energy n-type and p-type semiconductor portions. A voltage is generated by such spatial charge separation.

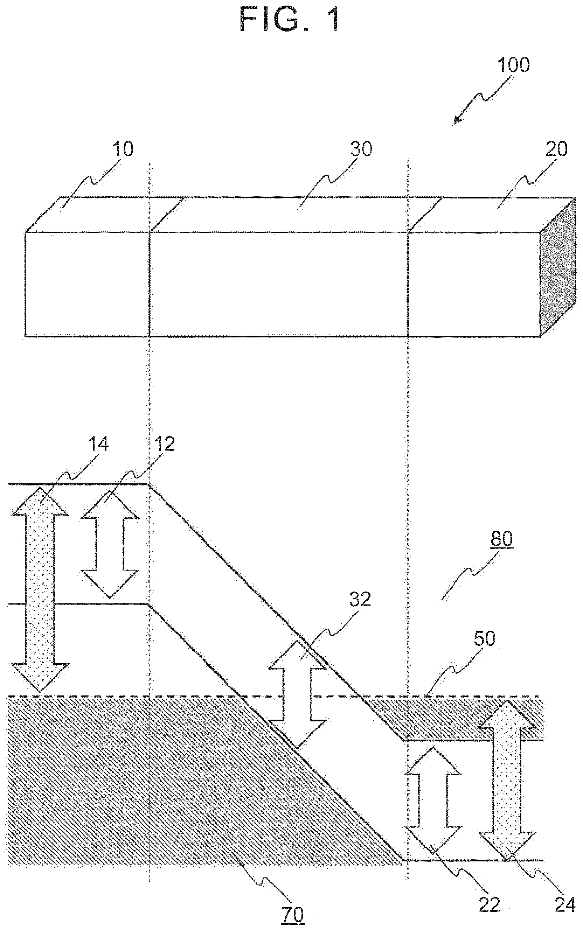

Specifically, for example, in the case where both p-type and n-type semiconductor portions of the thermoelectric conversion element of the invention are degenerate semiconductors, the bandgap in a depletion layer 30 (shown by arrow 32) can be made smaller than the magnitude of the energy for exciting electron-hole pairs in a p-type semiconductor portion 10 (shown by arrow 14) and the magnitude of the energy for exciting electron-hole pairs in an n-type semiconductor portion 20 (shown by arrow 24), as shown in the lower part of FIG. 1. The thermoelectric conversion element of the invention can thus generate power even without a temperature difference.

In the thermoelectric conversion element of the invention, as shown in FIG. 1, the bandgaps of the materials forming the p-type semiconductor portion 10, the n-type semiconductor portion 20, and the depletion layer 30 are substantially the same as shown by arrows 12, 22, and 32. In the thermoelectric conversion element of the invention, however, both of the p-type semiconductor portion 10 and the n-type semiconductor portion 20 are degenerate semiconductors. That is, the Fermi level 50 in the p-type semiconductor portion 10 lies in a valence band 70, and the Fermi level 50 in the n-type semiconductor portion 20 lies in a conduction band 80. The energy for exciting electron-hole pairs in the p-type semiconductor portion 10 (shown by arrow 14) and the energy for exciting electron-hole pairs in the n-type semiconductor portion 20 (shown by arrow 24) can therefore be increased. Accordingly, in the thermoelectric conversion element of the invention, the bandgap in the depletion layer 30 (shown by arrow 32) is smaller than the magnitude of the energy for exciting electron-hole pairs in the p-type semiconductor portion 10 (shown by arrow 14) and the magnitude of the energy for exciting electron-hole pairs in the n-type semiconductor portion 20 (shown by arrow 24).

Similarly, for example, in the case where only the p-type semiconductor portion 10 in the thermoelectric conversion element of the invention is a degenerate semiconductor, that is, in the case where the Fermi level 50 in the p-type semiconductor portion 10 lies in the valence band 70 and the Fermi level 50 in the n-type semiconductor portion 20 lies in the bandgap, the bandgap in the depletion layer 30 (shown by the arrow 32) can be made smaller than the magnitude of the energy for exciting electron-hole pairs in the p-type semiconductor portion 10 (shown by arrow 14), as shown in the lower part of FIG. 2. The thermoelectric conversion element of the invention can therefore generate power even without a temperature difference.

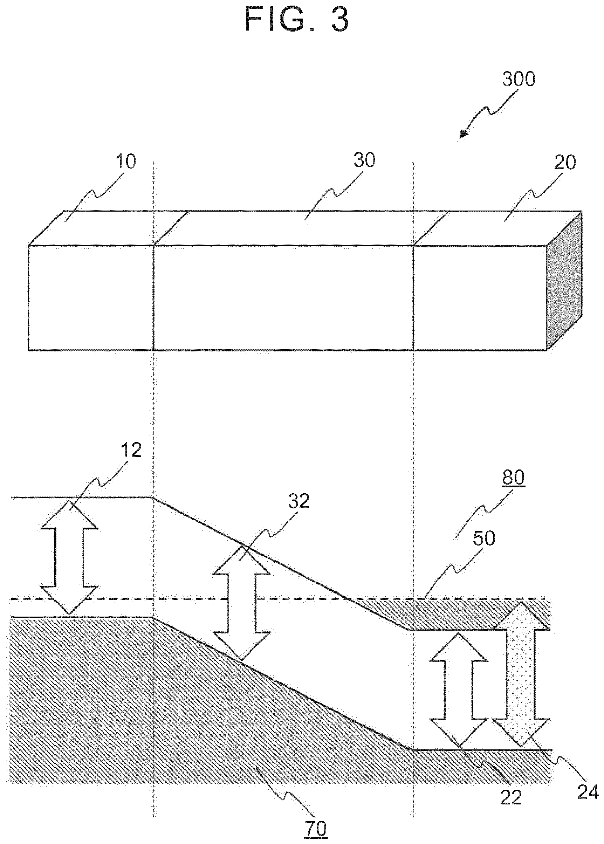

Moreover, for example, in the case where only the n-type semiconductor portion 20 in the thermoelectric conversion element of the invention is a degenerate semiconductor, that is, in the case where the Fermi level 50 in the p-type semiconductor portion 10 lies in the bandgap and the Fermi level 50 in the n-type semiconductor portion 20 lies in the conduction band 80, the bandgap in the depletion layer 30 (shown by the arrow 32) can be made smaller than the magnitude of the energy for exciting electron-hole pairs in the n-type semiconductor portion 20 (shown by arrow 24), as shown in the lower part of FIG. 3. The thermoelectric conversion element of the invention can therefore generate power even without a temperature difference.

For reference, in the case of a semiconductor device 400 in which neither the p-type semiconductor portion nor the n-type semiconductor portion is a degenerate semiconductor, the bandgap in the depletion layer 30 (shown by arrow 32) is substantially the same as the magnitude of the energy for exciting electron-hole pairs in the p-type semiconductor portion 10 and the magnitude of the energy for exciting electron-hole pairs in the n-type semiconductor portion 20, namely the bandgaps of the materials forming the p-type semiconductor portion 10 and the n-type semiconductor portion 20 (shown by arrows 12 and 22).

In the thermoelectric conversion element of the invention, the bandgaps of the materials forming the p-type semiconductor portion, the n-type semiconductor portion, and the depletion layer may be substantially the same.

In the thermoelectric conversion element of the invention, the p-type semiconductor portion 10, the n-type semiconductor portion 20, and the depletion layer 30 may be comprised of the same semiconductor material, for example, silicon (bandgap: about 1.2 eV), and the p-type and n-type semiconductor portions 10, 20 may be doped with p-type and n-type dopants. That is, in the thermoelectric conversion element of the invention, the p-type semiconductor portion 10 may be silicon doped with a p-type dopant, and the n-type semiconductor portion 20 may be silicon doped with an n-type dopant.

The p-type dopant can be selected from the group consisting of boron, aluminum, gallium, indium, palladium, and combinations of at least two of them, and the n-type dopant can be selected from the group consisting of phosphorus, antimony, arsenic, titanium, and combinations of at least two of them.

Preferably, in the thermoelectric conversion element of the invention, the p-type semiconductor portion 10 is silicon doped with boron as a p-type dopant, and the n-type semiconductor portion 20 is silicon doped with phosphorus as an n-type dopant.

The thermoelectric conversion element of the invention can be produced by any process, and in particular, can be produced by a process that is known in the field of semiconductor technology.

Accordingly, for example, the thermoelectric conversion element of the invention can be produced by preparing silicon powder doped with a p-type dopant and silicon powder doped with an n-type dopant, stacking and depositing them, and forming a pn junction by a sintering process such as spark plasma sintering (SPS).

For example, the thermoelectric conversion element of the invention can also be produced by diffusing an n-type dopant into a silicon substrate doped with a p-type dopant or diffusing a p-type dopant into a silicon substrate doped with an n-type dopant.

### Thermoelectric Conversion System

A thermoelectric conversion system of the invention includes two or more thermoelectric conversion elements of the invention electrically connected in series.

Since the thermoelectric conversion system of the invention includes two or more thermoelectric conversion elements of the invention electrically connected in series, it can produce a high-voltage current. The thermoelectric conversion system of the invention may include two or more thermoelectric conversion elements of the invention electrically connected in parallel.

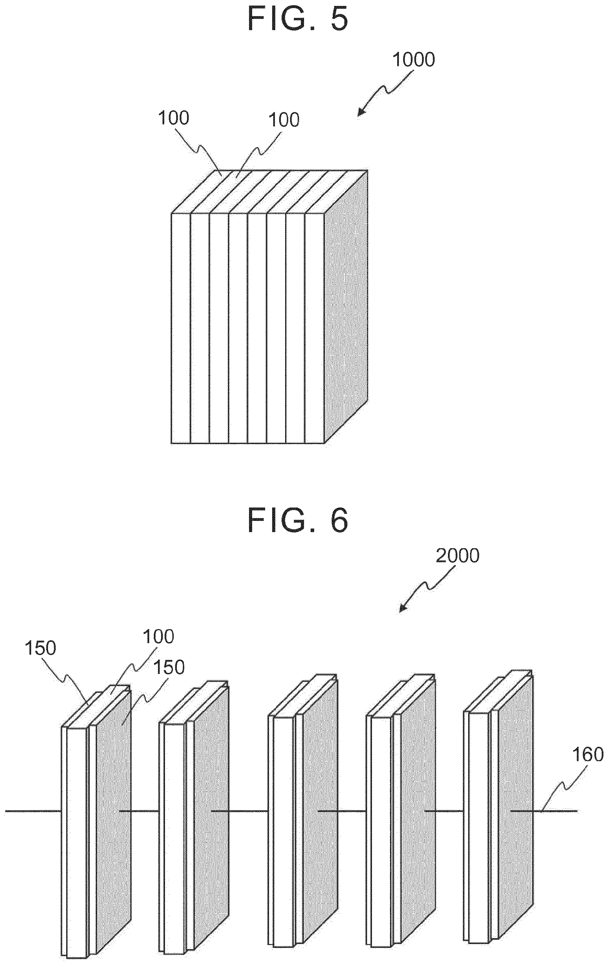

In the thermoelectric conversion system of the invention, the thermoelectric conversion elements of the invention can be electrically connected in series in any manner. For example, as shown in FIG. 5, a thermoelectric conversion system 1000 may have thermoelectric conversion elements 100 of the invention directly stacked together. As shown in FIG. 6, a thermoelectric conversion system 2000 may have thermoelectric conversion elements 100 of the invention connected in series via electrodes 150 and/or a conductive wire 160.

### Power Generation Method

In a power generation method of the invention, the thermoelectric conversion element of the invention or the thermoelectric conversion system of the invention is heated to 50°C or higher to generate power.

The thermoelectric conversion element of the invention or the thermoelectric conversion system of the invention can generate high-voltage power as it is heated to a high temperature. For example, this temperature may be 100°C or higher, 150°C or higher, 200°C or higher, 250°C or higher, 300°C or higher, 350°C or higher, 400°C or higher, 450°C or higher, or 500°C or higher. In order to restrain degradation of the thermoelectric conversion element or the thermoelectric conversion system, this temperature may be 1,000°C or lower, 950°C or lower, 900°C or lower, 850°C or lower, 800°C or lower, 750°C or lower, 700°C or lower, 650°C or lower, 600°C or lower, 550°C or lower, or 500°C or lower.

Waste heat from an internal combustion engine, waste heat from a motor, waste heat from a battery, waste heat from an inverter, waste heat from a factory, waste heat from a power station, etc. can be used as a heat source for power generation by the power generation method of the invention.

In the case where means of transportation such as an automobile generates power by the power generation method of the invention, it can use waste heat from an engine such as a gasoline or diesel engine, a motor for an electric or hybrid vehicle, a battery for an electric or hybrid vehicle, or an inverter for an electric or hybrid vehicle, etc. In these cases, the thermoelectric conversion element or the thermoelectric conversion system of the invention can be disposed in a hood, a bulkhead, an underbody, an engine oil passage, a cooling water passage, etc.

### Production of Thermoelectric Conversion Element

Each of p-type silicon doped with boron serving as a p-type dopant (boron doping concentration: 6.5 × 10¹⁹ cm³, specific resistance: 1.7 mΩ·cm) and n-type silicon doped with phosphorus serving as an n-type dopant (phosphorus doping concentration: 7.4 × 10¹⁹ cm³, specific resistance: 1.0 mΩ·cm) was pulverized into powder.

The p-type silicon powder and the n-type silicon powder thus obtained were stacked in a carbon die for spark plasma sintering so that the p-type silicon powder was layered on top of the n-type silicon powder. The stack of the p-type silicon powder and the n-type silicon powder was sintered by spark plasma sintering into a compact having p-type and n-type semiconductor portions and a depletion layer formed at the pn junction interface of the p-type and n-type semiconductor portions.

A sample with a length of 10 mm, a width of 5 mm, and a thickness of 1.5 mm was cut out from this sintered compact so as to include the pn junction interface, and this sample was used as a thermoelectric conversion element of an example.

The Seebeck coefficient of this thermoelectric conversion element was measured by thermal mapping. The Seebeck coefficient was -0.1275 µV/K in the p-type semiconductor portion and 0.1275 µV/K in the n-type semiconductor portion and continuously changed between the p-type semiconductor portion and the n-type semiconductor portion.

### Power Generation by Thermoelectric Conversion Element

The thermoelectric conversion elements of the example produced as described above was placed in an atmosphere from room temperature to 500°C and the electromotive force at each temperature was measured. The results are shown in FIG. 7. The relationship between the current and the voltage at each temperature was also measured. The results are shown in FIG. 8.

As can be seen from FIGS. 7 and 8, the electromotive force produced by the thermoelectric conversion element of the example increased as the ambient temperature rose, and the electromotive force was about 6.0 mV at 500°C.

In order to examine the influence of temperature non-uniformity in the atmosphere and an error of a measurement apparatus on power generation of the thermoelectric conversion element of the example, an evaluation apparatus was attached to the thermoelectric conversion element of the example with its p-type and n-type semiconductor portions inverted. Namely, the evaluation apparatus was attached to the inverted thermoelectric conversion element of the example. According to the evaluation results, in this case as well, the electromotive force produced by the thermoelectric conversion element of the example increased as the ambient temperature rose, and the electromotive force was about 6.0 mV at 500°C. The evaluation results thus confirmed that power generation of the thermoelectric conversion element of the example was not caused by temperature non-uniformity in the atmosphere, an error of the measurement apparatus, etc.

As described above, the electromotive force per thermoelectric conversion element of the example is about 6.0 mV at 500°C. This means that 10,000 thermoelectric conversion elements of the embodiment connected in series can generate an electromotive force of 60 V when the internal resistance is not considered, and shows that the thermoelectric conversion element of the example is useful.

The thermoelectric conversion element of the example produced as described above was also placed in an atmosphere from room temperature to 600°C and the electromotive force at each temperature was measured. The results are shown in FIG. 9.

The results show that when the temperature of the thermoelectric conversion element was raised from 500°C to 600°C, the electromotive force was further increased, and the electromotive force was about 12.0 mV at 600°C.

## Claims

1. A thermoelectric conversion element (100, 200, 300) comprising:
a p-type semiconductor (10);
an n-type semiconductor (20); and
a depletion layer (30) located at a pn junction interface of the p-type semiconductor (10) and the n-type semiconductor (20), wherein
at least one of the p-type semiconductor (10) and the n-type semiconductor (20) is a degenerate semiconductor.

2. The thermoelectric conversion element (100, 200, 300) according to claim 1, wherein
both the p-type semiconductor (10) and the n-type semiconductor (20) are degenerate semiconductors.

3. The thermoelectric conversion element (100, 200, 300) according to claim 1 or 2, wherein
bandgaps of materials forming the p-type semiconductor (10), the n-type semiconductor (20), and the depletion layer (30) are substantially a same.

4. The thermoelectric conversion element (100, 200, 300) according to any one of claims 1 to 3, wherein
the p-type semiconductor (10) is silicon doped with a p-type dopant, and the n-type semiconductor (20) is silicon doped with an n-type dopant.

5. The thermoelectric conversion element (100, 200, 300) according to claim 4, wherein
the p-type dopant is selected from the group consisting of boron, aluminum, gallium, indium, palladium, and combinations of at least two of the boron, the aluminum, the gallium, the indium, and the palladium, and the n-type dopant is selected from the group consisting of phosphorus, antimony, arsenic, titanium, and combinations of at least two of the phosphorus, the antimony, the arsenic, and the titanium.

6. The thermoelectric conversion element (100, 200, 300) according to claim 5, wherein
the p-type semiconductor (10) is silicon doped with the boron serving as the p-type dopant, and the n-type semiconductor (20) is silicon doped with the phosphorus serving as the n-type dopant.

7. A thermoelectric conversion system (1000, 2000) comprising:
two or more of the thermoelectric conversion elements (100, 200, 300) according to any one of claims 1 to 6, the thermoelectric conversion elements (100, 200, 300) being electrically connected in series.

8. A power generation method of the thermoelectric conversion element (100, 200, 300) according to any one of claims 1 to 6, the power generation method comprising:
heating the thermoelectric conversion element (100, 200, 300) to 100°C or higher to cause the thermoelectric conversion element (100, 200, 300) to generate power.

9. A power generation method of the thermoelectric conversion system (1000, 2000) according to claim 7, the power generation method comprising:
heating the thermoelectric conversion system (1000, 2000) to 100°C or higher to cause the thermoelectric conversion system (1000, 2000) to generate power.
